(19) Europäisches Patentamt
European Patent Office
Office européen des brevets

(11) **EP 1 743 428 B1**

(12) **EUROPÄISCHE PATENTSCHRIFT**

(45) Veröffentlichungstag und Bekanntmachung des Hinweises auf die Patenterteilung:
**21.10.2009  Patentblatt 2009/43**

(21) Anmeldenummer: **05740257.0**

(22) Anmeldetag: **04.05.2005**

(51) Int Cl.:
***H03M 1/52*** *(2006.01)*

(86) Internationale Anmeldenummer:
**PCT/EP2005/052060**

(87) Internationale Veröffentlichungsnummer:
**WO 2005/112268 (24.11.2005 Gazette 2005/47)**

(54) **VORRICHTUNG ZUR ANALOG/DIGITAL WANDLUNG EINER MESSSPANNUNG**

DEVICE FOR THE ANALOG/DIGITAL CONVERSION OF A MEASURING VOLTAGE

DISPOSITIF DE CONVERSION ANALOGIQUE/NUMERIQUE D'UNE TENSION DE MESURE

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **07.05.2004  DE 102004023145**

(43) Veröffentlichungstag der Anmeldung:
**17.01.2007  Patentblatt 2007/03**

(73) Patentinhaber: **ENDRESS + HAUSER WETZER GmbH + Co. KG**
**D-87484 Nesselwang (DE)**

(72) Erfinder:
• **HÄRLE, Thomas**
**87466 Oy-Mittelberg (DE)**
• **KONRAD, Stefan**
**87669 Rieden (DE)**

(74) Vertreter: **Andres, Angelika Maria**
**Endress+Hauser (Deutschland) AG+Co. KG**
**PatServe**
**Colmarer Strasse 6**
**79576 Weil am Rhein (DE)**

(56) Entgegenhaltungen:
**WO-A-93/17502          DE-A1- 4 037 268**
**DE-C1- 4 403 732       GB-A- 1 390 063**
**US-A- 4 584 566        US-A- 4 999 632**
**US-A- 5 097 264        US-A- 5 157 400**
**US-A- 5 184 128        US-A- 5 519 361**
**US-A1- 2003 016 154    US-A1- 2003 053 587**
**US-B1- 6 243 034**

• **PATENT ABSTRACTS OF JAPAN Bd. 014, Nr. 568 (E-1014), 18. Dezember 1990 (1990-12-18) & JP 02 246622 A (SONY CORP), 2. Oktober 1990 (1990-10-02)**

**Beschreibung**

Die Erfindung bezieht sich auf eine Vorrichtung zur Analog/Digital Wandlung einer Messspannung.

Ein Verfahren zur A/D Wandlung, also zur Umsetzung einer analogen Eingangsspannung in eine zur Amplitude proportionalen digitalen Zahl, stellt das Zählverfahren dar. Ausgestaltungen des Zählverfahrens sind das Ein-Rampen-Verfahren und das Zwei-Rampen-Verfahren, wobei bei dem zuerst genannten Verfahren nur die Eingangsspannung und bei dem an zweiter Stelle genannten Verfahren die Eingangsspannung und die Referenzspannung mittels eines Integriergliedes integriert werden.

Die Periodendauer für die A/D-Wandlung eines Messsignals wird durch die Summe der Entladezeit t1 und der Aufladezeit t2 eines Kondensators festgelegt, der im Rückkoppelkreis des Integriergliedes angeordnet ist. Die Umschaltung zwischen der Aufladephase und der Entladephase erfolgt jeweils zu dem Zeitpunkt, wenn die Ausgangsspannung des Integriergliedes eine vorgegebene Schwellspannung erreicht. Realisiert wird dies über einen nachgeschalteten Komparator, an dessen einem Eingang die Ausgangsspannung des Integriergliedes und an dessen anderem Ausgang die Schwellspannung anliegt. Wie zum Beispiel in US-B-6285310 gezeigt.

Um die Periodendauer des pulsweitenmodulierten Ausgangssignals zu messen, wird die Zeit zwischen zwei steigenden oder zwei fallenden Flanken des pulsweitenmodulierten Ausgangssignals mittels eines Zählers erfasst. Die Auflösung bei der Bestimmung der Periodendauer ist hierbei abhängig von der Frequenz des Zählertaktes: Je höher der Zählertakt, um so besser ist die zeitliche Auflösung. Wird beispielsweise der Zähler mit dem Zählertakt f betrieben, so gilt für die kleinste messbare Zeitänderung Δt:

$$\Delta t = 1 / f$$

Bekannte A/D-Wandler sind natürlich um so teurer, je höher ihre Auflösung ist. Darüber hinaus ist die Auflösung bekannter A/D-Wandler üblicherweise fest vorgegebenen, so dass üblicherweise ein auf den jeweiligen Anwendungsfall optimal abgestimmter A/D-Wandler zum Einsatz gebracht wird.

In der Prozessmesstechnik geht die Tendenz in Richtung von Multiparameter-Messgeräten, also Messgeräte, die in der Lage sind, mehrere unterschiedliche physikalische oder chemische Prozeßgrößen zu messen. Bei den Prozessgrößen handelt es sich z.B. um die Temperatur, den Druck, den Füllstand, den Durchfluss, den pH-Wert, die Ionenkonzentration, die Leitfähigkeit, usw. eines Messmediums. Die 'Güte' einer Messung wird prinzipiell durch die Messgenauigkeit und/oder die zeitliche Auflösung der Messung also die Messrate bestimmt. Üblicherweise sind diese beiden Anforderungen zueinander gegenläufig: Für eine hochgenaue Messung braucht es eine entsprechend lange Zeit; ist hingegen die Zeit für eine Messung beschränkt, so geht die erhöhte Messrate auf Kosten der Messgenauigkeit. Den Ausweg stellen A/D-Wandler, die entsprechend schnell sind und die gleichzeitig eine hohe Bit-Auflösung haben. Der Nachteil dieser A/D-Wandler ist, dass sie relativ teuer sind, was die Fertigungskosten für die Messgeräte erheblich in die Höhe treibt.

Gerade im Hinblick auf Multiparameter-Messgeräte kommt noch ein weiterer Aspekt hinzu: In der Prozessmesstechnik werden an die Messwertbereitstellung, sprich an die A/D-Wandlung der Messsignale, die die einzelnen Prozessgrößen repräsentieren, hinsichtlich Messgenauigkeit und hinsichtlich zeitlicher Auflösung unterschiedliche Anforderungen gestellt: Als Beispiel sei die Temperatur genannt, eine Prozessgröße, die sich über die Zeit üblicherweise relativ langsam ändert, da im Normalfall keine abrupten Temperatursprünge auftreten. Allerdings ist gerade bei Temperaturmessungen üblicherweise eine hohe Messgenauigkeit gefordert. Erwähnt sei in diesem Zusammenhang die Überwachung und/oder Regelung der Temperatur in einem chemischen Prozess. Da sich die Temperatur relativ langsam ändert, steht für die Messwerterfassung relativ viel Zeit zur Verfügung.

Ganz anders sieht es z. B. bei einer Druckmessung aus: hier ist es notwendig, auch plötzlich auftretende Drucksprünge detektieren zu können. Dies ist nur möglich, wenn die Meßdauer entsprechend kurz ist; bei vielen Druckmessungen ist jedoch die Messgenauigkeit von untergeordneter Bedeutung. Sinnvoll ist in diesem Zusammenhang also das Auffinden eines Kompromisses bzw. einer flexiblen Lösung, die es erlaubt, die Messwerterfassung hinsichtlich Messgenauigkeit und hinsichtlich Messdauer an die jeweils gestellten Anforderungen anzupassen.

Der Erfindung liegt die Aufgabe zugrunde, eine kostengünstige Vorrichtung zur A/D-Wandlung von Messsignalen bereitzustellen, die flexibel auf die jeweilige Messaufgabe abstimmbar ist.

Die Aufgabe wird durch eine Vorrichtung mit folgendem Aufbau gelöst: Der Analog/Digital-Wandler weist ein Integrierglied mit einem Operationsverstärker, einem Widerstand und einer Kapazität im Rückkopplungskreis auf. Am invertierendem Eingang des Operationsverstärkers liegt eine Referenzspannung und am nicht-invertierendem Eingang des Operationsverstärkers liegt die Messspannung bzw. die Eingangsspannung an. Während einer Aufladephase einer vorgegebenen Zeitdauer wird der Kondensator aufgeladen und während einer Entladephase wird der Kondensator entladen.

Weiterhin umfasst der Analog/Digital-Wandler einen dem Operationsverstärker nachgeschalteten Komparator, ein dem Komparator nachgeschaltetes Speicherelement, einen die Aufladezeit erzeugenden Zeitgenerator und einen Zähler, wobei der Zähler die Flanken (bzw. die Periodendauer) des von dem A/D-Wandler am Ausgang bereitgestellten pulsweitenmodulierten Ausgangssignals detektiert. Bei dem Speicherelement handelt es sich gemäß einer bevorzugten Ausgestaltung um einen R-S-FlipFlop. Desweiteren ist ein Synchronisationselement vorgesehen, das zumindest innerhalb einer vorgegebenen Messdauer die Flanken des pulsweitenmodulierten Ausgangssignals mit dem Takt des Zählers synchronisiert.

Wie bereits zuvor erwähnt, erfolgt ohne Synchronisation des pulsweitenmodulierten Ausgangssignals mit dem Takt des Zählers die Umschaltung zwischen der Aufladephase und der Entladephase immer exakt beim Erreichen der eingestellten oder vorgegebenen Schwellspannung, also zu dem Zeitpunkt, an dem die während der Aufladephase im Kondensator des Integriergliedes gespeicherte Ladung wieder entladen ist. Erfindungsgemäß werden die Flanken des pulsweitenmodulierten Ausgangssignals mit dem Zählertakt über ein Synchronisationselement synchronisiert. Hierdurch findet die Umschaltung zwischen der Entladephase und der Aufladephase nicht bei Erreichen der Schwellspannung, sondern erst beim nächsten Takt des Zählers statt, also bei einem Spannungswert, der oberhalb der Schwellspannung liegt. Das Integrierglied wird also dazu gezwungen, trotz Erreichens der Schwellspannung bis zum Auftreten des nächsten Zählertaktes weiterzuintegrieren. Dadurch ergibt sich eine Restladung im Kondensator des Integriergliedes. Dieser Vorgang wiederholt sich bei jeder nachfolgenden Wandlung: Die Restladungen werden aufaddiert, bis schließlich nach einer gewissen Anzahl von Wandlungen eine sprunghafte Änderung des Zählenrvertes auftritt.

Gemäß einer bevorzugten Ausgestaltung der erfindungsgemäßen Vorrichtung ist ein Taktgeber vorgesehen, der einen Systemtakt vorgibt, und wobei das Synchronisationselement den Zähler, den Analog-/Digital-Wandler und den Zeitgenerator mit dem Systemtakt synchronisiert. Der Vorteil dieser Ausgestaltung, dass alle Takte von demselben Systemtakt abgeleitet werden ist darin zu sehen, dass Taktdriften, die z.B. aufgrund von Temperaturänderungen oder über eine lange Betriebsdauer auftreten können, keinen Einfluss auf die Güte der Wandlung haben.

Eine vorteilhafte Weiterbildung der erfindungsgemäßen Vorrichtung sieht einen Analogschalter vor, der die Referenzspannung, die an dem invertierenden Eingang des Operationsverstärkers anliegt, zwischen zwei unterschiedlichen Spannungswerten schaltet. Diese Weiterbildung hat den Vorteil, dass die Referenzspannung, die am invertierenden Eingang des Operationsverstärkers anliegt, frei wählbar bzw. beliebig einstellbar ist. Ist eine freie wählbare Referenzspannung nicht erforderlich, so kann auf den Analogschalter verzichtet werden. Beispielsweise kann die Ausgangsspannung des Synchronisationselements als Referenzspannung auf den invertierenden Eingang des Operationsverstärkers gegeben werden. Handelt es sich bei dem Synchronisationselement - wie eine vorteilhafte Weiterbildung der Erfindung vorschlägt - um einen D-FlipFlop, so entspricht bei dieser alternativen Lösung die Betriebsspannung des D-FlipFlops der am invertierenden Eingang des Operationsverstärkers anliegenden Referenzspannung.

Darüber hinaus schlägt eine vorteilhafte Ausgestaltung der erfindungsgemäßen Vorrichtung vor, dass der Zähler einen Captur-Compare-Eingang aufweist. Der Zähler ist jeweils während einer vorgegebenen Messdauer eingeschaltet und detektiert die Flanken des pulsweitenmodulierten Ausgangssignals. Prinzipiell ist eine korrekte Arbeitsweise natürlich nur dann möglich, wenn innerhalb der gewählten Messdauer zumindest eine Periode des pulsweitenmoduliertes Ausgangssignal liegt. Bei jeder detektierten Flanke des pulsweitenmodulierten Ausgangssignals wird ein interrupt erzeugt. Weiterhin sieht eine bevorzugte Ausgestaltung der erfindungsgemäßen Vorrichtung einen Mikroprozessor vor, der die Eingangsspannung aus den durch die Interrupts erzeugten Zählerwerten, insbesondere über eine Mittelwertbildung von mehreren Zählerwerten bestimmt.

Es wird im Zusammenhang mit der erfindungsgemäßen Lösung als besonders vorteilhaft angesehen, dass dem Mikroprozessor eine Speichereinheit zugeordnet ist. In der Speichereinheit ist die Anzahl der während einer vorgegebenen Messdauer durch die Flanken des pulsweitenmodulierten Ausgangssignals erzeugten Interrupts gespeichert. Der Mikroprozessor errechnet die Eingangsspannung nach Ablauf der vorgegebenen Messdauer nach der folgenden Formel:

$$Ue = \frac{t_1 U_H}{Z - Z1} \bullet (I - 1)$$

wobei die Variable Z1 dem ersten Zählerwert entspricht, wobei Z die nachfolgenden Zählerwerte repräsentiert, die überschreibend in der Speichereinheit gespeichert werden, wobei die Anzahl der während der Messdauer gezählten Interrupts widerspiegelt, t1 die Aufladezeit und UH die Referenzspannung, die an dem Integrierglied anliegt.

Als besonders vorteilhaft wird die Ausgestaltung der erfindungsgemäßen Vorrichtung erachtet, dass der Mikroprozessor Unter- und Überspannungen erkennt und ein entsprechendes Fehlersignal generiert. Eine Unterspannung lässt sich beispielsweise einfach dadurch feststellen, dass innerhalb der Messdauer nicht mindestens zwei Flanken der pulsweitenmodulierten Ausgangsspannung bzw. nicht mindestens zwei Interrupts detektiert werden. Eine Überspannung macht sich dadurch erkennbar, dass die Abarbeitungzeit der Interrupts länger ist als die zu messende Periodendauer. Um Messfehler zu vermeiden, muss hier die Anzahl der auftretenden Interrupts nach oben hin begrenzt werden.

Alternativ ist vorgesehen, dass der Mikroprozessor die Messdauer so anpasst, dass das Auftreten von Unter- und/oder Überspannungen vermieden wird.

Die Erfindung wird anhand der nachfolgenden Zeichnungen näher erläutert. Es zeigt:

Fig. 1: ein Blockschaltbild des erfindungsgemäßen A/D-Wandlers,

Fig. 2: eine graphische Darstellung der in Fig. 1 gekennzeichneten Spannungen an unterschiedlichen Komponenten des erfindungsgemäßen A/D-Wandlers,

Fig. 3: eine graphische Darstellung, in der die Ausgangsspannung Ua des Operationsverstärkers über den Zählerwerten des Zählers im Laufe eines Messzyklus' aufgetragen ist, und

Fig. 4: eine graphische Darstellung, in der die Fehler der Zeitmessung über der Anzahl der gemittelten Messwerte aufgetragen ist.

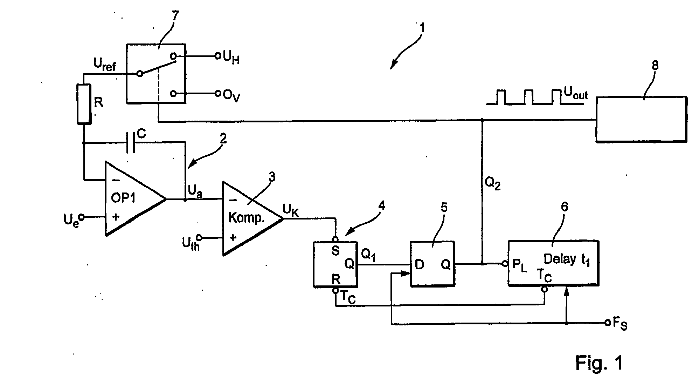

Fig. 1 zeigt ein Blockschaltbild des erfindungsgemäßen A/D-Vandlers 1. Der erfindungsgemaße Analog/Digital- Wandler 1 setzt sich aus folgenden Komponenten zusammen:

- dem Integrierglied 2, bestehend aus dem Operationsverstärker OP1, dem Widerstand R und der Kapazität C im Rückkopplungskreis;
- dem Komparator 3;
- dem Speicherelement 4, hier dem R-S FlipFlop 4;
- dem Synchronisationselement 5, hier dem D-FlipFlop 5;
- dem Zeitgenerator 6;

Gemäß einer bevorzugten in der Zeichnung dargestellten Variante der Erfindung synchronisiert das Synchronisationselement 5 den Analog/ Digital-Wandler 1, den Zähler 8 und den Zeitgenerator 6 mit dem Systemtakt Ts. Möglich ist es auch - wie bereits erwähnt - dass anstelle des Systemtakts Ts auf den Zählertakt f synchronisiert wird.

Optional ist ein Analogschalter 7 vorgesehen. Auf diesen kann verzichtet werden, wenn eine frei wählbarer Referenzspannung Uref nicht erforderlich ist. Ist es nicht notwendig, dass die Referenzspannung Uref frei wählbar ist, so kann z.B. direkt die Ausgangsspannung Q2 des Synchronisationselements 5 oder bei Betrieb ohne Synchronisation die Ausgangsspannung Q1 des Speicherelementes 4 als Referenzspannung Uref verwendet werden. In diesem Fällen entspricht also die Betriebsspannung des D-FlipFlops 5 oder des R-S- FlipFlops 4 gleichzeitig der Referenzspannung Uref, die am invertierenden Eingang des Operationsverstärkers OP1 anliegt.

Der A/D-Wandler 1 weist drei Eingänge und einen Ausgang auf:

- am ersten Eingang liegt die Eingangsspannung Ue an;
- am zweiten Eingang liegt die Referenzspannung UH an;
- am dritten Eingang der Systemtakt Ts.

Am Ausgang des A/D-Wandlers 1 wird das pulsweitenmodulierte Ausgangssignal Uout bereitgestellt, das die digitale Umsetzung des analogen Messsignals Ue repräsentiert.

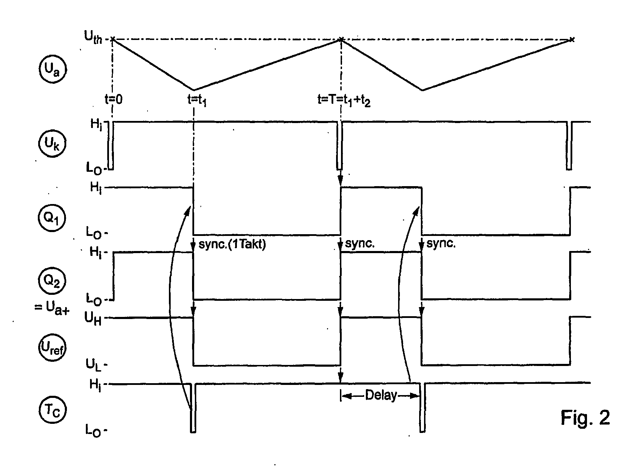

Der als Integrierglied 2 arbeitende Operationsverstärker OP1 wird während einer von dem Zeitgenerator 6 vorgegebenen Zeitdauer t1 - in der Aufladephase - aufgeladen. Anschließend wird die Zeitdauer t2 der Entladephase gemessen. Die Zeitdauer t2 entspricht der Zeit, die es braucht, bis am Ausgang des Integrierglieds 2 aufgrund des sich entladenden Kondensators C eine gewisse Ausgangsspannung Ua gemessen wird. Üblicherweise entspricht diese der Schwellspannung Uth; erfindungsgemäß erfolgt die Umschaltung durch die Synchronisation mit dem Zähler aber bei einer Spannung, die oberhalb der vorgegebenen Schwellspannung liegt. Der zeitliche Verlauf der an den einzelnen Komponenten anliegenden Spannung Ua, UK, Q1, Q2 bzw. der zeitliche Verlauf der von den einzelnen Komponenten gelieferten Spannung Uref, TC ist in Fig. 2 gesondert dargestellt.

Zum Zeitpunkt t = 0 beginnt die sog. Aufladephase. Diese ist in der Fig. 2 mit (1) gekennzeichnet. Im Zeitpunkt t = 0 steht über die entsprechende Schaltung des Analogschalters 7 die Spannung UH an dem invertierenden Eingang des Operationsverstärkers OP1 an. Wenn die Referenzspannung UH größer ist als die Eingangsspannung Ue, fällt die Spannung Ua am Ausgang des Operationsverstärkers OP1, ausgehend von der Schwell-spannung Uth, linear ab. Der Ausgang des Komparators 3, der Ausgang Q1 des R-S-FlipFlops 4, der Ausgang Q2 des D-FlipFlops 5, der dem puls- modulierten Ausgangssignal Uout entspricht, und der Ausgang des Zeit-generators 6 befinden sich während dieser Zeit auf dem binären Pegel Hi. Zum Zeitpunkt t1 lässt sich die am Ausgang des Integriergliedes 2 anstehende Ausgangsspannung Ua folgendermaßen beschreiben:

$$Ua(t1) = Uth + \frac{1}{RC}(Ue - UH) \bullet t1 \qquad (1)$$

Nach Ablauf der zwischen den Zeitpunkten t = 0 und t1 liegenden Zeitdauer erzeugt der Zeitgenerator 6 am Ausgang TC einen kurzen Clock-Impuls auf den binären Pegel Lo. Hierdurch wird ein Reset-Signal am R-S-FlipFlop 4 erzeugt; als Folge hiervon werden das Ausgangssignal Q1 und einen Takt später das Ausgangssignal Q2 auf den binären Pegel Lo gesetzt. Weiterhin schaltet der Analogschalter 7 die Referenzspannung Uref auf 0V, und es beginnt die Entladephase, die in der Fig. 2 mit (2) gekennzeichnet ist.

Wenn die Referenzspannung 0V kleiner ist als die Eingangsspannung Ue, steigt die Ausgangsspannung Ua linear an. Zum Zeitpunkt t2 erreicht die Spannung Ua wieder die Schwellspannung Uth, und der Komparator 3 schaltet. Hierdurch wird die Ausgangsspannung UK des Komparators 3 auf den binären Pegel Lo gesetzt; weiterhin wird der R-S-FlipFlop 4 gesetzt (→ SET). Q1 liegt auf dem binären Pegel Hi, und einen Takt später liegt die Ausgangsspannung des D-FlipFlops Q2 auf dem binären Pegel Hi. Q2 dient zur Umschaltung der Referenzspannung Uref und zur Freigabe des Zeitgenerators 6. Die Aufladephase (1) beginnt erneut. Zum Zeitpunkt T = t1 + t2 lässt sich die Ausgangsspannung Ua durch die folgende Formel mathematisch beschreiben:

$$Ua(T) = Uth = Ua(t1) + \frac{1}{RC} Ue \bullet t2 \qquad (2)$$

Durch Einsetzen von Ua(t1) aus Formel (1) in die Formel (2) ergibt sich im eingeschwungenen Zustand des A/D-Wandlers 1 die folgende Beziehung zwischen der Eingangsspannung Ue und der Periodendauer T:

$$Ue = \frac{UH \bullet t1}{T} \qquad (3)$$

Sind die Referenzspannung UH und die vorgegebene Verzögerungszeit t1 - Delay t1 - bekannt und konstant, so ergibt sich die folgende mathematische Beziehung:

$$Ue = \frac{UH \bullet t1}{T} = \frac{A}{T} \sim \frac{1}{T} \qquad (4)$$

Die Eingangsspannung Ue ist unter diesen Bedingungen also indirekt bzw. umgekehrt proportional zur Periodendauer T, wobei T = t1 + t2 ist.

Um die Periodendauer T zu messen, wird die Zeit zwischen zwei steigenden Flanken oder zwei abfallenden Flanken des pulsweitenmodulierten Ausgangssignals Uout mit dem Zähler 8 erfasst. Die Zeitauflösung der Periodendauer T hängt dabei ganz wesentlich von der Frequenz f des Zählertaktes des Zählers 8 ab. Wird der Zähler 8 mit dem Systemtakt Ts betrieben, so gilt für die kleinste messbare Zeitänderung Δt die folgende mathematische Beziehung:

$$\Delta t = \frac{1}{Ts} \qquad (5)$$

Diese übliche Auflösungsgrenze wird bei dem erfindungsgemäßen A/D-Wandler 1 aufgehoben.

Ohne Synchronisation auf den Systemtakt Ts oder auf den Zählertakt des Zählers 8 erfolgt die Umschaltung zwischen der Entladephase (2) und der Aufladephase (1) immer exakt beim Erreichen der Schwellspannung Uth, also zu einem Zeitpunkt, wenn die während der Aufladephase (1) im Integrierglied 2 gespeicherte Ladung wieder entladen ist. Erfindungsgemäß wird der A/D-Wandler 1 und der Zähler 8 mit dem Systemtakt Ts oder mit dem Zählertakt f des Zählers 8 synchronisiert.

Durch die Synchronisation des A/D-Wandlers 1, des Zählers 8 und des Zeitgenerators 6 mit dem Systemtakt Ts bzw. mit dem Zählertakt f findet die zuvor genannte Umschaltung erst beim nächsten Takt des Systemtakts Ts bzw.

des Zählertaktes f statt. Die Umschaltung zwischen den beiden Phasen findet also nicht bei Uth, sondern oberhalb von Uth statt. Dadurch ergibt sich eine Restladung im Integrierglied 2, die sich mit jeder Wandlung aufaddiert und schließlich zu einen Sprung des Zählerwertes führt. Es entsteht ein Zyklus von Messwerten mit der Auflösung des Zählers 8. Eine Mittelwertbildung über n Messwerte dieses Zyklus' erhöht die Auflösung um mindestens den Faktor n. Je höher die Anzahl der gemittelten Messwerte, um so besser ist auch die Auflösung A. Eine Verdopplung der gemittelten Messwerte führt mindestens zu einer Verdopplung der Auflösung und damit zu einer Verdopplung der Messgenauigkeit.

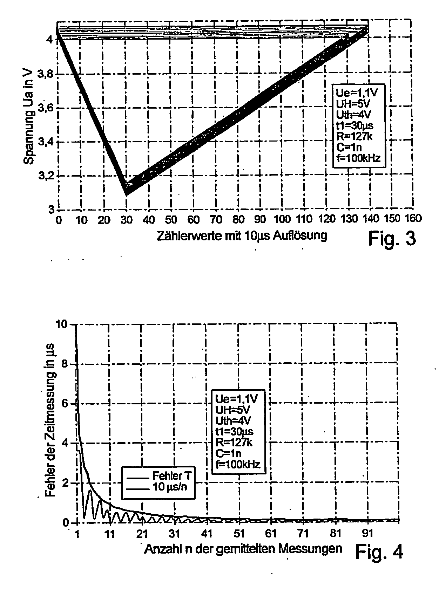

In Fig. 3 ist beispielhaft für einen Zyklus die Spannung Ue in Abhängigkeit von den Zählerwerten des Zählers 8 dargestellt. Hier ist dargstellt, wie sich die Ausgangsspannung Ua des Integriergliedes 2 während eines Zyklus', in dem eine Vielzahl von Auflade- und Entladephasen durchlaufen werden, über die Zeit ändert. Bei einer Taktfrequenz von 10 kHz haben die Zählerwerte eine Auflösung von 10 μsec. Während des Zyklus' erzeugt der Zähler 8 viermal den Zählerwert 130 μsec und siebenmal den Zahlerwert 140 μsec. Im Mikroprozessor 10 wird der Mittelwert über die elf Messwerte gebildet, so dass man den exakten Wert 136,3636 μsec erhält, obwohl die eigentliche Auflösung des Zählers nur 10 μsec beträgt.

Beispielhaft ist in Fig. 4 der Auflösungsgewinn dargestellt, der bei der erfindungsgemäßen Vorrichtung durch die Mittelwertbildung erreicht wird. Insbesondere ist hier der Fehler in der Zeitmessung gegen die Anzahl n der in einem Zyklus durchgeführten Messungen aufgetragen. Bezogen auf das in Fig. 3 gezeigte Beispiel wird der Fehler bei einer Mittelwertbildung über n = 11 Messungen zu Null. Garantiert werden kann allerdings nur die Hüllkurve 1/n. Theoretisch lässt sich mit der erfindungsgemäßen Lösung eine beliebig große Auflösung erreichen, wenn das Messfenster bzw. die Meßdauer entsprechend erhöht wird. Die erhöhte Messgenauigkeit geht zwar auf Kosten der Messgeschwindigkeit, jedoch spielt dies je nach Art der Anwendung bzw. je nach Art der Messung nur eine untergeordnete Rolle. Praktisch werden der Auflösung übrigens Grenzen durch das Auftreten von Rauschen und von Nichtlinearitäten gesetzt.

Durch den in Formel (3) dargestellten nichtlinearen Zusammenhang zwischen der Eingangsspannung Ue und der Periodendauer T ist die Auflösung der gemessenen Spannung nicht linear. Große Eingangsspannungen Ue ergeben kleine Periodendauern T und werden niedriger aufgelöst. Erfindungsgemäß wird bevorzugt der nachfolgend genannte Algorithmus zur Auswertung verwendet:

Ein Zähler mit Captur-Compare-Eingang wird für eine Messdauer X (z.B. X = 4ms) eingeschaltet. Die Zählerstände bei den durch die Flanken des pulsweitenmodulierten Signals Uout erzeugten Interrupts I werden wie folgt in der Speichereinheit 11 gespeichert. Der erste Zählerwert wird in eine Variable Z1 gespeichert; die folgenden überschreibend in die Variable Z. Die Anzahl der Interrupts wird in einer Variablen I festgehalten. Nach Ablauf der Messdauer X kann nun die Spannung Ue wie folgt errechnet werden:

$$Ue = \frac{e}{Z-Z1} \bullet (I - 1) \quad (6)$$

Eine kleine Eingangsspannung Ue, die eine Periodendauer T etwas kleiner als X erzeugt, wird also nicht gemittelt und mit der Auflösung des Zählers 8 gemessen. Eine große Eingangsspannung Ue, die eine sehr kleine Periodendauer T erzeugt, wird sehr oft gemessen und gemittelt, wobei die Auflösung durch die zuvor beschriebene Methode erhöht wird. Die kleinste Auflösung hat deshalb ein Signal mit einer Periodendauer T = X/2. Die Auflösung A des A/D-Wandlers 1 lässt sich folglich durch die nachfolgende Formel beschreiben:

$$A = \frac{X}{2} \bullet Ts \quad (7)$$

Beträgt die Messdauer beispielsweise X = 4ms und der Systemtakt Ts = 8MHz, so beträgt die Auflösung A des erfindungsgemäßen A/D-Wandlers 1 A= 16.000 bzw. 14 Bit.

In der Software des Mikroprozessors 10 werden die folgenden Fehler abgefangen:

Eine Unterspannung wird erkannt, wenn keine zwei Flanken des pulsweitenmodulierten Ausgangssignals bzw. keine zwei Interrupts während der Messdauer X auftreten. Dies ist ein Indikator dafür, dass die Messspannung bzw. die Eingangsspannung Ue zu klein ist.

Eine Überspannung ist dadurch erkennbar, dass die Abarbeitungszeit TI der Interrupts länger als die Periodendauer T wird, und es kommt zum Meßfehler. Deshalb ist es erforderlich, die maximale Anzahl der Interrupts auf X/TI zu begrenzen.

Nachfolgend sind noch einmal die Vorteile der erfindungsgemäßen Vorrichtung genannt:

Folgende Fehler gehen prinzipiell nicht in die Messung ein:

- Wird der Zeitgenerator 6 mit dem Zählertakt f synchronisiert, so beeinflusst das Driften der Vorladezeit t1 (z.B. aufgrund von Temperaturänderungen oder über Betriebsdauer) das Messergebnis nicht;
- Werden alle Takte der Schaltungskomponenten 6, 8,1 von dem gleichen Takt Ts abgeleitet, so spielen Driften des Taktes Ts (z.B. aufgrund von Temperaturänderungen oder über Betriebsdauer) keine Rolle;
- Ebenso wirken sich Schwankungen in der Schwellspannung Uth und bei dem RC-Glied nicht negativ auf das Messergebnis aus, solange die Schwankungen nicht innerhalb eines Messzyklus' auftreten;
- Weiterhin haben Schaltzeiten der Digitalschaltung, die Einfluss auf die Zeitdauer t2 der Entladephase haben, keinen Einfluss auf das Messergebnis.

Weiterhin lassen sich durch den Zwei-Punkte-Abgleich die folgenden Fehler eliminieren:

- Alle analogen Offsetgrößen am Operationsverstärker OP1 (da hier nur eine Drift einen Messfehler erzeugen kann.)
- Der Wert der On-Widerstände des Analogschalters 7
- Die Schaltzeiten, die auf die Zeitdauer t1 der Aufladephase wirken.
- Der Absolutfehler der Referenzspannung UH (auch hier kann nur eine Drift einen Messfehler erzeugen).

**Bezugszeichenliste**

| | |
|---|---|
| 1 | A/D-Wandler |
| 2 | Integrierglied |
| 3 | Komparator |
| 4 | S-R-FlipFlop / Speicherelement |
| 5 | D-FlipFlop / Synchronisationselement |
| 6 | Zeitgenerator |
| 7 | Analogschalter |
| 8 | Zähler |
| 9 | Taktgeber |
| 10 | Mikroprozessor |
| 11 | Speichereinheit |

| | |
|---|---|
| OP1 | Operationsverstärker |
| R | Widerstand |
| C | Kondensator |
| Uout | pulsweitenmoduliertes Ausgangssignal |
| Ue | Messspannung |
| Ua | Ausgangssignal des Operationsverstärkers |
| Uref | Referenzspannung |
| Uth | Schwellspannung |
| Q1 | Spannung am Speicherelement |
| Q2 | Spannung am Synchronisationselement |

**Patentansprüche**

1. Vorrichtung zur Analog/Digital Wandlung einer Messspannung (Ue) mit einem Analog/Digital-Wandler (1), der ein Integrierglied (2) mit einem Operationsverstärker (OP1), einem Widerstand (R) und einer Kapazität (C) im Rückkopplungskreis aufweist, wobei am invertierendem Eingang des Operationsverstärkers (OP1) eine Referenzspannung (Uref) anliegt und wobei am nicht-invertierendem Eingang des Operationsverstärkers (OP1) die Messspannung (Ue) anliegt, wobei der Kondensator (C) während einer Aufladephase mit einer Aufladezeit (t1) aufgeladen und während einer Entladephase mit einer Entladezeit (t2) entladen wird, wobei die Summe von Aufladezeit (t1) und Endladezeit (t2) einer Periodendauer (T) entspricht, wobei der Analog/Digital-Wandler (1) weiterhin einen dem Operationsverstärker (OP1) nachgeschalteten Komparator (3), ein dem Komparator (3) nachgeschaltetes Speicherelement (4), einen die Aufladezeit (t1) erzeugenden Zeitgenerator (6) und einen Zähler (8) umfasst, wobei am invertierenden Eingang des Komparators (3) die Ausgangsspannung (Ua) des Integriergliedes (2) und am nicht-invertierenden Eingang des Komparators (3) eine Schwellenspannung (Uth) anliegt, wobei der A/D-Wandler (1) an seinem Ausgang ein pulsweitenmoduliertes Ausgangssignal (Uout) mit Flanken und der Periodendauer (T = t1 + t2) bereitstellt, wobei der Zähler (8) die Flanken bzw. die Periodendauer (T = t1 + t2) des pulsweitenmodulierten Ausgangssignals (Uout) detektiert, **dadurch gekennzeichnet, dass** die Referenzspannung (Uref) und die Entladezeit (t1) konstant sind, so dass die Eingangsspannung (Ue) umgekehrt proportional zur Periodendauer (T) ist, und wobei ein Synchronisationselement (5) vorgesehen ist, das innerhalb einer vorgegebenen Messdauer mit einer Vielzahl von Auflade- und Entladephasen die Flanken des pulsweitenmodulierten Ausgangssignals (Uout) mit dem Takt des Zählers (8) synchronisiert, wobei eine Umschaltung zwischen der Auflade- und Entladephasen durch die Synchronisation mit dem Zähler (8) bei einer Ausgangsspannung (Ua) erfolgt, die oberhalb der Schwellenspannung (Uth) liegt, wodurch innerhalb der vorgegebenen Messdauer ein Zyklus von n Messwerten mit der Auflösung des Zählers (8) entsteht

2. Vorrichtung nach Anspruch 1,
wobei ein Mikroprozessor vorgesehen ist, der den Mittelwert der n Messwerte bildet, wodurch die Auflösung des A/D-Wandlers (1) um mindestens den Faktor n erhöht wird.

3. Vorrichtung nach Anspruch 1,
wobei ein Analogschalter (7) vorgesehen ist, der die Referenzspannung (Uref), die an den invertierenden Eingang des Operationsverstärkers (OP1) anliegt, zwischen zwei unterschiedlichen Spannungswerten (UH, Masse) schaltet.

4. Vorrichtung nach Anspruch 1 oder 3,
wobei als Referenzspannung (Uref) die am Ausgang des Synchronisationselements (5) zur Verfügung stehende Spannung (Q2) auf den invertierenden Eingang des Operationsverstärkers (OP1) geführt ist.

5. Vorrichtung nach Anspruch 1,
wobei als Referenzspannung (Uref) die am Ausgang des Speicherelements (4) zur Verfügung stehende Spannung (Q1) auf den invertierenden Eingang des Operationsverstärkers (OP1) geführt ist.

6. Vorrichtung nach Anspruch 1,
wobei es sich bei dem Speicherelement (4) um einen R-S-FlipFlop handelt.

7. Vorrichtung nach Anspruch 1 oder 4,
wobei es sich bei dem Synchronisationselement (4) um einen D-FlipFlop handelt.

8. Vorrichtung nach Anspruch 1,
wobei der Zähler (8) einen Captur-Compare-Eingang aufweist, wobei der Zähler (8) jeweils während der vorgegebenen Messdauer eingeschaltet ist und die Flanken des pulsweitenmodulierten Ausgangssignals (Uout) als Zählerwerte detektiert und wobei ein Mikroprozessor vorgesehen ist, der die Eingangsspannung (Ue) aus den Zählerwerten, insbesondere über eine Mittelwertbildung von mehreren Zählerwerten bestimmt.

9. Vorrichtung nach Anspruch 1 oder 8,
wobei dem Mikroprozessor eine Speichereinheit zugeordnet ist, wobei in der Speichereinheit die Anzahl der durch die Flanken des pulsweiten-modulierten Ausgangssignals (Uout) erzeugten Interrupts (I) gespeichert ist und wobei der Mikroprozessor (9) die Eingangsspannung (Ue) nach Ablauf der Messdauer nach der folgenden Formel errechnet:

$$Ue = \frac{a}{Z - Z1} \cdot (I - 1)$$

wobei die Variable Z1 dem ersten Wert des Zählers (8) entspricht, wobei Z die nachfolgenden Zählerwerte repräsentiert, die überschreibend in der Speichereinheit gespeichert werden, und wobei die Größe I die Anzahl der während der Messdauer gezählten Interrupts widerspiegelt, und wobei a eine Konstante darstellt.

10. Vorrichtung nach Anspruch 8 oder 9,
wobei der Mikroprozessor Unter- und Überspannungen erkennt und ein Fehlersignal generiert.

11. Vorrichtung nach Anspruch 10,
wobei der Mikroprozessor die Messdauer so anpasst, dass das Auftreten von Unter- und/oder Überspannungen vermieden wird.

12. Vorrichtung nach Anspruch 1 oder 2,
wobei der Zähler (8) mit dem Systemtakt (Ts) betrieben ist.

**Claims**

1. Unit for the analog/digital conversion of a measurement voltage (Ue) with an analog to digital converter (1), exhibiting an integration element (2) with an operational amplifier (OP1), a resistor (R) and a capacitance (C) in the feedback circuit,
where a reference voltage (Uref) is present at the inverting input of the operational amplifier (OP1) and where the measurement voltage (Ue) is present at the noninverting input of the operational amplifier (OP1),
where the capacitor (C) is charged during a charging phase with a charging time (t1) and is discharged during a discharging phase with the discharging time (t2), **characterized in that** the sum of the charging time (t1) and the discharging time (t2) corresponds to a periodic time (T),
where the analog to digital converter (1) further comprises a comparator (3) downstream from the operational amplifier (OP1), a storage element (4) downstream from the comparator (3), a time generator (6) generating the charging time (t1) and a counter (8),
where the output voltage (Ua) of the integration element (2) is present at the inverting input of the comparator (3) and a threshold voltage (Uth) is present at the noninverting input of the comparator (3),
where the A/D converter (1) makes a pulse-width modulated output signal (Uout) available at its output with edges and the period duration (T = t1 + t2),
where the counter (8) detects the edges or the period duration (T = t1 + t2) of the pulse-width modulated output signal (Uout), **characterized in that** the reference voltage (Uref) and the discharge time (t1) are constant such that the input voltage (Ue) is inversely proportional to the period duration (T), and where a synchronization element (5) is provided that synchronizes the edges of the pulse-width modulated output signal (Uout) with the cycle of the counter (8) within a specified measuring duration with a number of charging and discharging phases, whereby the system switches between the charging and discharging phases through synchronization with the counter (8) at an output voltage (Ua) that is above the threshold voltage (Uth), which results in a cycle of n measured values during the specified measuring duration with the resolution of the counter (8).

2. Unit as per Claim 1, where a microprocessor is provided that calculates the mean value of the n measured values, which increases the resolution of the A/D converter (1) by at least a factor n.

3. Unit as per Claim 1, where an analog switch (7) is provided which switches the reference voltage (Uref) present at the inverting input of the operational amplifier (OP1) between two different voltage values (UH, ground).

4. Unit as per Claim 1 or 3, where the voltage (Q2) available at the output of the synchronization element (5) is guided to the inverting input of the operational amplifier (OP1) as the reference voltage (Uref).

5. Unit as per Claim 1, where the voltage (Q1) available at the output of the storage element (4) is guided to the inverting input of the operational amplifier (OP1) as the reference voltage (Uref).

6. Unit as per Claim 1, where the storage element (4) is an R-S flip-flop.

7. Unit as per Claim 1, where the synchronization element (4) is a D flip-flop.

8. Unit as per Claim 1, where the counter (8) exhibits a capture-compare input, where the counter (8) is switched on during the specified measuring duration and detects the edges of the pulse-width modulated output signal (Uout) as counter values, and
where a microprocessor is provided that determines the input voltage (Ue) from the counter values, particularly by calculating the mean value of the several counter values.

9. Unit as per Claim 1 or 8, where a storage unit is assigned to the microprocessor, **characterized in that** the number of interrupts (I) generated by the edges of the pulse-width modulated output signal (Uout) is saved in the storage unit, and **characterized in that** the microprocessor (9) uses the following formula to calculate the input voltage (Ue) on completion of the measuring duration:

$$Ue = \frac{a}{z-z1} * (I-1)$$

The variable Z1 corresponds to the first value of the counter (8), Z represents the subsequent counter values that are saved in the storage unit, the variable I stands for the number of interrupts counted during the measuring duration and a is a constant.

**10.** Unit as per Claim 8 or 9, where the microprocessor detects sub-voltages or excess voltages and generates an error signal.

**11.** Unit as per Claim 10, where the microprocessor adapts the measuring duration in such a way that the occurrence of sub-voltages and/or excess voltages is avoided.

**12.** Unit as per Claim 1 or 2, where the counter (8) is operated with the system clock (Ts).

**Revendications**

**1.** Dispositif destiné à la conversion analogique-numérique d'une tension de mesure (Ue) à l'aide d'un convertisseur analogique-numérique (1), lequel comporte un circuit d'intégration (2) composé d'un amplificateur opérationnel (OP1), d'une résistance (R) et d'un condensateur (C) dans le circuit de contre-réaction, une tension de référence (Uref) étant appliquée à l'entrée inverseuse de l'amplificateur opérationnel (OP1) et la tension de mesure (Ue) étant appliquée à l'entrée non inverseuse de l'amplificateur opérationnel (OP1), le condensateur (C) étant chargé pendant une phase de charge d'un durée de charge (t1) et déchargé pendant une phase de décharge d'une durée de décharge (t2), la somme de la durée de charge (t1) et de la durée de décharge (t2) correspondant à une durée de période (T), le convertisseur analogique-numérique comprenant en outre un comparateur (3) placé en aval de l'amplificateur opérationnel (OP1), un élément de mémoire (4) placé en aval du comparateur (3), un générateur de temps (6) générant la durée de charge (t1) et un compteur (8), la tension de sortie (Ua) du circuit d'intégration (2) étant appliquée à l'entrée inverseuse du comparateur (3) et une tension de seuil (Uth) étant appliquée à l'entrée non inverseuse du comparateur (3), le convertisseur analogique-numérique (1) mettant à disposition à sa sortie un signal de sortie (Uout) modulé en largeur d'impulsions, avec des fronts et la durée de période (T = t1 + t2) du signal de sortie (Uout) modulé en largeur d'impulsions, le compteur (8) détectant les fronts ou la durée de période (T = t1 + t2) du signal de sortie (Uout) modulé en largeur d'impulsions, **caractérisé en ce que** la tension de référence (Uref) et la **durée de décharge (t2)** sont constantes, de telle manière que la tension d'entrée (Ue) soit inversement proportionnelle à la durée de période (T), et un élément de synchronisation (5) étant prévu, lequel synchronise les fronts du signal de sortie (Uout) modulé en largeur d'impulsions avec la cadence du compteur (8) au sein d'une durée de mesure prédéfinie constituée d'un grand nombre de phases de charge et de décharge, une commutation entre les phases de charge et de décharge intervenant par la synchronisation avec le compteur (8) à une tension de sortie (Ua), qui est supérieure à la tension de seuil (Uth), ce par quoi il en résulte un cycle de n valeurs mesurées avec la résolution du compteur (8) au sein de la durée de mesure prédéfinie.

**2.** Dispositif selon la revendication 1,
pour lequel est prévu un microprocesseur, qui calcule la valeur moyenne des n valeurs mesurées, ce par quoi la résolution du convertisseur analogique-numérique (1) est augmentée au minimum du facteur n.

**3.** Dispositif selon la revendication 1,
pour lequel est prévu un interrupteur analogique (7), qui commute la tension de référence (Uref), qui est appliquée à l'entrée inverseuse de l'amplificateur opérationnel (OP1), entre deux valeurs de tension distinctes (UH, masse).

**4.** Dispositif selon la revendication 1 ou 3,
pour lequel la tension (Q2), mise à disposition en tant que tension de référence (Uref) à la sortie de l'élément de synchronisation (5), est appliquée à l'entrée inverseuse de l'amplificateur opérationnel (OP1).

**5.** Dispositif selon la revendication 1,
pour lequel la tension (Q1), mise à disposition en tant que tension de référence (Uref) à la sortie de l'élément de mémoire (4), est appliquée à l'entrée inverseuse de l'amplificateur opérationnel (OP1)

**6.** Dispositif selon la revendication 1,
pour lequel il s'agit, concernant l'élément de mémoire, d'une bascule RS.

**7.** Dispositif selon la revendication 1 ou 4,
pour lequel il s'agit, concernant l'élément de synchronisation, d'une bascule D.

**8.** Dispositif selon la revendication 1,
pour lequel le compteur (8) présente une entrée de capture et de comparaison, le compteur (8) étant à chaque fois activé pendant la durée de mesure prédéfinie et les fronts du signal de sortie (Uout) modulé en largeur d'impulsions étant détectés en tant que valeurs du compteur et un microprocesseur étant prévu, lequel détermine la tension d'entrée (Ue) à partir des valeurs du compteur, notamment au moyen d'un calcul de la moyenne de plusieurs valeurs du compteur.

**9.** Dispositif selon la revendication 1 ou 8,
pour lequel une unité de mémoire est attribuée au microprocesseur, le nombre d'interruptions (I) générées par les fronts du signal de sortie (Uout) modulé en largeur d'impulsions étant enregistré dans l'unité de mémoire et le microprocesseur (9) calculant la tension d'entrée (Ue) après l'écoulement de la durée de mesure d'après la formule suivante :

$$Ue = a\ /\ (Z\text{-}Z1)\ *\ (I - 1)$$

la variable Z1 correspondant à la première valeur du compteur (8), Z représentant les valeurs du compteur suivantes, qui sont enregistrées par écrasement dans l'unité de mémoire, et la grandeur I reflétant le nombre d'interruptions comptées pendant la durée de mesure, et a représentant une constante.

**10.** Dispositif selon la revendication 8 ou 9,
pour lequel le microprocesseur détecte des sous-tensions et surtensions et génère un signal de défaut.

**11.** Dispositif selon la revendication 10,
pour lequel le microprocesseur adapte la durée de mesure de telle manière à éviter l'apparition de sous-tensions et/ou surtensions.

**12.** Dispositif selon la revendication 1 ou 2, pour lequel le compteur (8) est synchronisé avec l'horloge système (Ts).

Fig. 1

Fig. 2

Fig. 3

Fig. 4

**EP 1 743 428 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• US 6285310 B